(19) Europäisches Patentamt
European Patent Office
Office européen des brevets

(11) **EP 2 521 164 A1**

(12) **EUROPEAN PATENT APPLICATION**
published in accordance with Art. 153(4) EPC

(43) Date of publication:
**07.11.2012 Bulletin 2012/45**

(51) Int Cl.:
**H01L 21/205** (2006.01)  **H01L 31/075** (2012.01)

(21) Application number: **10841050.7**

(22) Date of filing: **28.12.2010**

(86) International application number:
**PCT/JP2010/073747**

(87) International publication number:
**WO 2011/081195 (07.07.2011 Gazette 2011/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.12.2009 JP 2009299094**

(71) Applicant: **Sharp Kabushiki Kaisha
Osaka-shi, Osaka 545-8522 (JP)**

(72) Inventors:
• **NASUNO, Yoshiyuki
Osaka-shi,
Osaka 545-8522 (JP)**

• **NISHIMURA, Kazuhito
Osaka-shi,
Osaka 545-8522 (JP)**
• **NAKANO, Takanori
Osaka-shi,
Osaka 545-8522 (JP)**

(74) Representative: **Müller - Hoffmann & Partner
Patentanwälte
Innere Wiener Strasse 17
81667 München (DE)**

(54) **SEMICONDUCTOR FILM AND PHOTOELECTRIC CONVERSION DEVICE**

(57)    There is provided a semiconductor film (2) formed on a surface of a substrate (1) and containing a crystalline substance, wherein the semiconductor film (2) has a central region (2b) including a center of a surface of the semiconductor film (2) and a peripheral region (2a) located around the central region (2b), and a crystallization ratio in the peripheral region (2a) of the semiconductor film (2) is higher than a crystallization ratio in the central region (2b). There is also provided a photoelectric conversion device including the semiconductor film (2).

FIG.3

(a)

CRYSTALLIZATION RATIO

SUBSTRATE SURFACE POSITION

PERIPHERY      CENTER      PERIPHERY

(b)

EASE OF PEELING

SUBSTRATE SURFACE POSITION

PERIPHERY      CENTER      PERIPHERY

EP 2 521 164 A1

## Description

TECHNICAL FIELD

The present invention relates to a semiconductor film and a photoelectric conversion device.

BACKGROUND ART

In recent years, problems of exhaustion of energy resources and global, environmental issues such as increasing $CO_2$ in the atmosphere have driven demands for development of clean energy. In particular, utilization of solar cells for photovoltaic power generation has been developed, been put into practical use, and been expanded as a new energy source.

The current most popular solar cell is a bulk crystal type solar cell in which a bulk crystal such as monocrystalline silicon or polycrystalline silicon is used in a photoelectric conversion layer converting light energy into electrical energy. Increase in amount of produced bulk crystal type solar cells leads to decline in price of solar cell modules, and thus, the spread of photovoltaic power generation systems is rapidly expanding.

Development of a thin film type solar cell is also in progress as a next-generation solar cell technique capable of significantly reducing an amount of used materials and further reducing the manufacturing cost as compared with the aforementioned bulk crystal type solar cell because a photoelectric conversion layer is formed of a thin film.

The thin film type solar cell as described above includes, for example, a thin film silicon solar cell (such as an amorphous silicon solar cell, a microcrystalline silicon solar cell, and an amorphous silicon/microcrystalline silicon tandem solar cell), a CIS ($CuInSe_2$) thin film solar cell, a CIGS ($Cu(In, Ga)Se_2$) thin film solar cell, a CdTe solar cell, and the like.

The aforementioned thin film type solar cell is generally fabricated by stacking thin films constituting a semiconductor layer and an electrode layer on a large-area substrate such as glass and metal foil by means of a vacuum film forming device such as a plasma CVD device, a sputtering device or a vapor deposition device.

Therefore, by increasing the area of the substrate surface and accordingly increasing the size of the manufacturing device, the large-area thin film type solar cell can be obtained in one film formation. Thus, the manufacturing efficiency can be enhanced and the manufacturing cost can be reduced in this respect as well.

PTL 1 (Japanese Patent Laying-Open No. 2009-38317), for example, discloses a microcrystalline silicon solar cell that is one example of the thin film type solar cell.

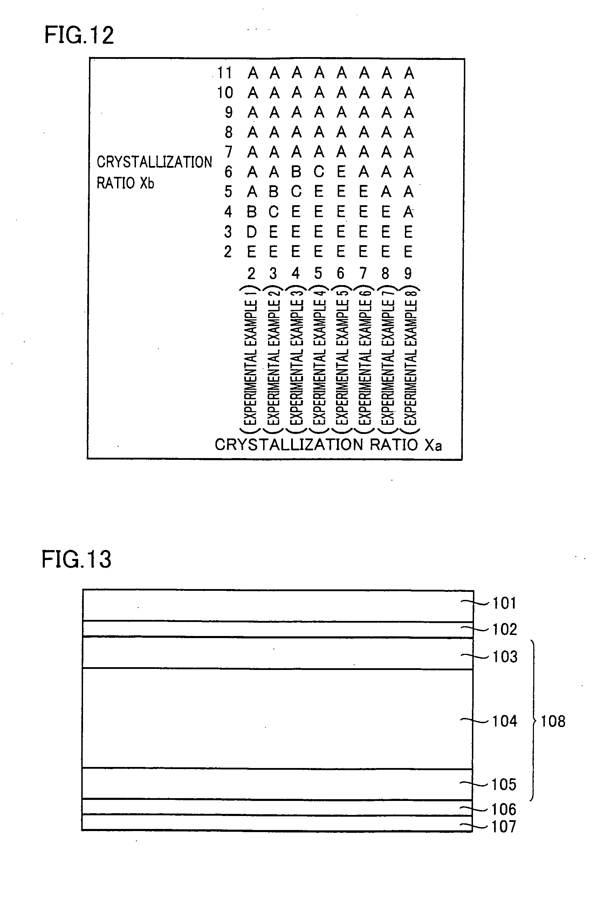

Fig. 13 shows a schematic cross-sectional view of the conventional microcrystalline silicon solar cell disclosed in PTL 1.

The conventional microcrystalline silicon solar cell shown in Fig. 13 is fabricated by sequentially stacking a first transparent electrode 102, a p-type microcrystalline Si layer (p layer) 103, an i-type microcrystalline Si layer (i layer) 104, an n-type microcrystalline Si layer (n layer) 105, a second transparent electrode 106, and a backside electrode 107 on a transparent insulating substrate 101. A stacked structure of p-type microcrystalline Si layer (p layer) 103, i-type microcrystalline Si layer (i layer) 104 and n-type microcrystalline Si layer (n layer) 105 constitutes a microcrystalline Si photoelectric conversion layer 108.

CITATION LIST

PATENT LITERATURE

PTL 1: Japanese Patent Laying-Open No. 2009-38317

SUMMARY OF INVENTION

TECHNICAL PROBLEM

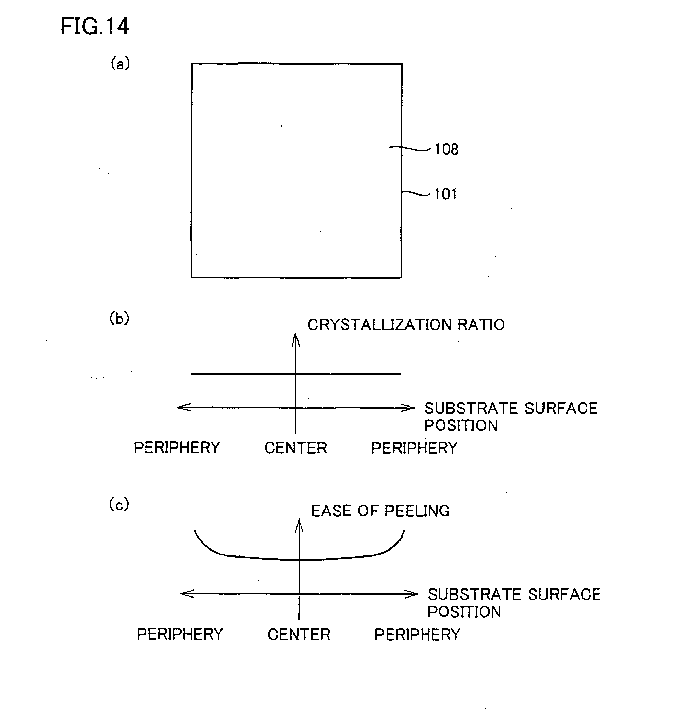

In the conventional microcrystalline silicon solar cell shown in Fig. 13, microcrystalline Si photoelectric conversion layer 108 is formed such that a crystallization ratio of microcrystalline silicon becomes uniform as shown in Fig. 14(b) from a center to a periphery of a surface of transparent insulating substrate 101 shown in Fig. 14(a).

Therefore, as shown in Fig. 14(c), microcrystalline Si photoelectric conversion layer 108 located on the periphery of the surface of transparent insulating substrate 101 peels off more easily than microcrystalline Si photoelectric conversion layer 108 located in the center of the surface of transparent insulating substrate 101.

The aforementioned problem is not a problem limited to the microcrystalline silicon solar cells but a problem common to the entire semiconductor devices that use a semiconductor film containing a crystalline substance.

In light of the aforementioned circumstances, an object of the present invention is to provide a semiconductor film capable of effectively suppressing peeling from a substrate, and a photoelectric conversion device including the semiconductor film.

SOLUTION TO PROBLEM

The present invention is directed to a semiconductor film formed on a surface of a substrate and containing a crystalline substance, wherein the semiconductor film has a central region including a center of a surface of the semiconductor film and a peripheral region located around the central region, and a crystallization ratio of the semiconductor film in the peripheral region is higher than a crystallization ratio in the central region.

Preferably, the crystallization ratio of the semiconductor film according to the present invention in the peripheral region is 4 or more.

In addition, preferably, the crystallization ratio of the semiconductor film according to the present invention in the central region is 2 or more.

In addition, preferably, in the semiconductor film according to the present invention, the surface of the semiconductor film has an area of 1 m² or larger.

In addition, in the semiconductor film according to the present invention, assuming that: a point A represents a center point of the surface of the semiconductor film; a point B represents one arbitrary point on an outer perimeter of the surface of the semiconductor film; a line segment AB represents a line segment connecting the point A and the point B; a point C and a point D represent two different points on the line segment AB; when a ratio of a length of a line segment AC connecting the point A and the point C, a length of a line segment CD connecting the point C and the point D, and a length of a line segment DB connecting the point D and the point B (AC:CD:DB) is 17:27:6, the central region is a region surrounded by a trajectory of the point C when the point A of the line segment AB is fixed and the point B goes around on the outer perimeter of the surface of the semiconductor film, and the peripheral region is a region between a trajectory of the point B and a trajectory of the point D when the point A of the line segment AB is fixed and the point B goes around on the outer perimeter of the surface of the semiconductor film; Xa represents the crystallization ratio of the semiconductor film in the central region; and Xb represents the crystallization ratio of the semiconductor film in the peripheral region, the crystallization ratio Xa and the crystallization ratio Xb preferably satisfy a following equation (i), and more preferably further satisfy a following equation (ii):

$$Xb \geq Xa+1 \cdots (i)$$

$$Xb \geq Xa+2 \cdots (ii).$$

In addition, the present invention is directed to a semiconductor film formed on a surface of a substrate and containing a crystalline substance, wherein the semiconductor film has a central region including a center of a surface of the semiconductor film and a peripheral region located around the central region, and assuming that: a point A represents a center point of the surface of the semiconductor film; a point B represents one arbitrary point on an outer perimeter of the surface of the semiconductor film; a line segment AB represents a line segment connecting the point A and the point B; a point C and a point D represent two different points on the line segment AB; when a ratio of a length of a line segment AC connecting the point A and the point C, a length of a line segment CD connecting the point C and the point D, and a length of a line segment DB connecting the point D and the point B (AC:CD:DB) is 17:27:6, the central region is a region surrounded by a trajectory of the point C when the point A of the line segment AB is fixed and the point B goes around on the outer perimeter of the surface of the semiconductor film, and the peripheral region is a region between a trajectory of the point B and a trajectory of the point D when the point A of the line segment AB is fixed and the point B goes around on the outer perimeter of the surface of the semiconductor film; Xa represents the crystallization ratio of the semiconductor film in the central region; and Xb represents the crystallization ratio of the semiconductor film in the peripheral region, the crystallization ratio Xa and the crystallization ratio Xb satisfy following equations (iii) and (iv):

$$Xb \geq 13 - Xa \cdots (iii)$$

$$Xa \geq Xb \cdots (iv).$$

In addition, the present invention is directed to a photoelectric conversion device fabricated by forming any one of the aforementioned semiconductor films on the substrate.

Furthermore, the present invention is directed to a photoelectric conversion device fabricated by cutting the aforementioned substrate of the photoelectric conversion device.

ADVANTAGEOUS EFFECTS OF INVENTION

According to the present invention, there can be provided a semiconductor film capable of effectively suppressing peeling from a substrate, and a photoelectric conversion device including the semiconductor film.

BRIEF DESCRIPTION OF DRAWINGS

Fig. 1 is a schematic enlarged cross-sectional view of one example of a semiconductor film according to the present invention.
Fig. 2 is a schematic plan view of one example of the semiconductor film shown in Fig. 1 as viewed two-dimensionally.
Fig. 3 (a) shows a relationship between a crystallization ratio of the semiconductor film shown in Fig. 1 and a position of a surface of the semiconductor film, and Fig. 3(b) shows a relationship between ease of peeling of the semiconductor film shown in Fig. 1 and a position of the surface of the semiconductor film.

Fig. 4 is a schematic plan view of another example of the semiconductor film shown in Fig. 1 as viewed two-dimensionally.

Fig. 5 is a schematic plan view of another example of the semiconductor film shown in Fig. 1 as viewed two-dimensionally.

Fig. 6 is a schematic configuration view of one example of a vacuum film forming device for forming the semiconductor film shown in Fig. 1.

Fig. 7 is a schematic cross-sectional view of one example of a photoelectric conversion device according to the present invention.

Figs. 8(a) to (c) are schematic perspective views illustrating one example of a method for manufacturing the photoelectric conversion device according to the present invention.

Fig. 9 is a schematic plan view of a glass substrate used for fabricating semiconductor films in Experimental Examples 1 to 8.

Fig. 10 shows a relationship between a distance (mm) from a center of a surface of the semiconductor film in each of Experimental Examples 1 to 8 and a crystallization ratio Ic/Ia.

Fig. 11 shows a relationship between a crystallization ratio Xa of the semiconductor film in each of Experimental Examples 1 to 8 in the center and a crystallization ratio Xb of the semiconductor film in each of Experimental Examples 1 to 8 in the outer perimeter.

Fig. 12 shows a result of checking whether or not peeling of the semiconductor film in each of Experimental Examples 1 to 8 occurs.

Fig. 13 is a schematic cross-sectional view of a conventional microcrystalline silicon solar cell.

Fig. 14(a) is a schematic plan view of a microcrystalline Si photoelectric conversion layer on a substrate of the conventional microcrystalline silicon solar cell, Fig. 14(b) shows a relationship between a position of a surface of a semiconductor film of the conventional microcrystalline silicon solar cell and a crystallization ratio of the microcrystalline Si photoelectric conversion layer, and Fig. 14(c) shows a relationship between a position of the surface of the semiconductor film of the conventional microcrystalline silicon solar cell and ease of peeling of the microcrystalline Si photoelectric conversion layer.

Fig. 15 is a schematic cross-sectional view of another example of the photoelectric conversion device according to the present invention.

DESCRIPTION OF EMBODIMENTS

Embodiments of the present invention will be described hereinafter. In the drawings of the present invention, the same reference characters indicate the same or corresponding portions.

<Configuration of Semiconductor Film>

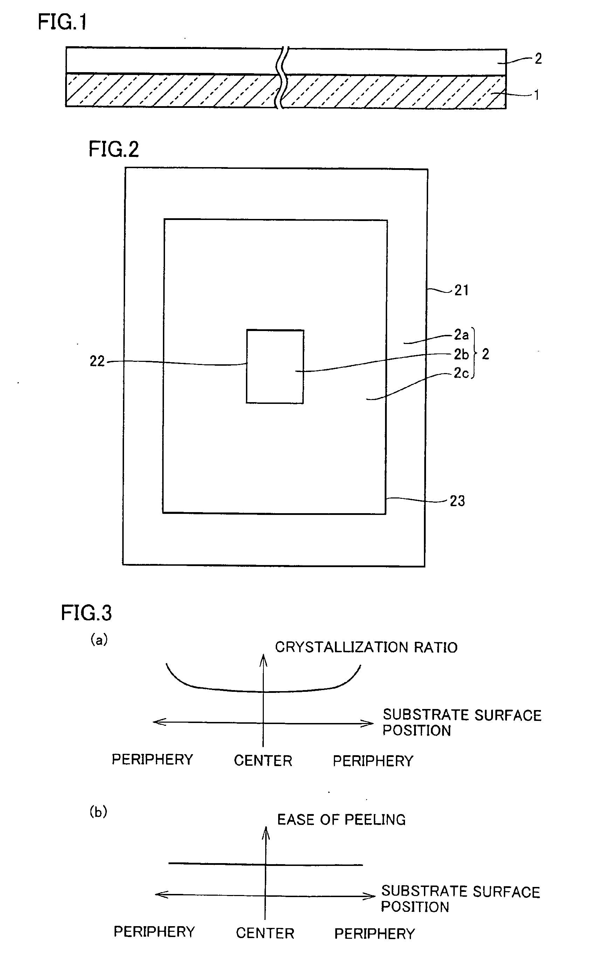

Fig. 1 shows a schematic enlarged cross-sectional view of one example of a semiconductor film according to the present invention. A semiconductor film 2 shown in Fig. 1 is provided on a surface of a substrate 1. Semiconductor film 2 provided on the surface of substrate 1 is formed of a semiconductor containing a crystalline substance.

For example, a glass substrate, a resin substrate containing a transparent resin such as a polyimide resin, or a translucent substrate that allows light to pass therethrough such as a substrate formed by stacking a plurality of these substrates can be used as substrate 1. For example, a non-translucent substrate that does not allow light to pass therethrough such as a stainless substrate may also be used as substrate 1.

A substrate including a transparent conductive film on a surface thereof may also be used as substrate 1. For example, a tin oxide film, an ITO (Indium Tin Oxide) film, a zinc oxide film, or a conductive film that allows light to pass therethrough, such as a single layer of a film formed by adding a minute amount of impurity to these films or a plurality of layers formed by stacking a plurality of these layers, can be used as the transparent conductive film. When the transparent conductive film is formed of the plurality of layers, all layers may be made of the same material or at least one layer may be made of a material different from that of the other layers.

Protrusions and recesses are preferably formed on the surface of substrate 1. Since the protrusions and recesses are formed on the surface of substrate 1, there is a tendency that incident light coming from the substrate 1 side can be scattered and/or refracted to extend the optical path length, and the light confining effect in semiconductor film 2 can be enhanced. For example, an etching method, a method by machining such as sandblast, a method using crystal growth, or the like can be used as a method for forming the protrusions and recesses on the surface of substrate 1.

At least one side of substrate 1 preferably has a width of 1 m or larger, and further, the surface of substrate 1 preferably has an area of 1 $m^2$ or larger. In this case, a surface of semiconductor film 2 has an area of 1 $m^2$ or larger, and thus, there can be manufactured a large-area photoelectric conversion device including semiconductor film 2 having the large-area surface.

Semiconductor film 2 is not particularly limited as long as semiconductor film 2 is the semiconductor containing the crystalline substance. For example, microcrystalline silicon and the like including crystalline silicon and amorphous silicon can be suitably used as semiconductor film 2. In the specification, "microcrystalline silicon" includes "hydrogenated microcrystalline silicon". "Microcrystalline silicon" also includes the case where elements such as O, C, N, and Ge are added.

Semiconductor film 2 may have any of p, i and n conductivity types. When semiconductor film 2 has the p conductivity type, boron and the like can be used, for example, as a p-type impurity with which semiconductor film 2 is doped. When semiconductor film 2 has the i conductivity type, semiconductor film 2 is not doped with the p-type impurity and an n-type impurity. When semiconductor film 2 has the n conductivity type, phosphorus and the like can be used, for example, as the n-type impurity with which semiconductor film 2 is doped.

Fig. 2 shows a schematic plan view of one example of semiconductor film 2 shown in Fig. 1 as viewed two-dimensionally (as viewed two-dimensionally from above the surface of semiconductor film 2). A central region 2b of semiconductor film 2 is a portion of semiconductor film 2 in a region including a center of the surface of semiconductor film 2 and surrounded by a solid line 22 in Fig. 2. A peripheral region 2a of semiconductor film 2 is a portion of semiconductor film 2 in a region between a solid line 21 and a solid line 23 in Fig. 2, which is located around central region 2b of semiconductor film 2. An intermediate region 2c of semiconductor film 2 is a portion of semiconductor film 2 in a region between central region 2b of semiconductor film 2 and peripheral region 2a of semiconductor film 2.

Fig. 3(a) shows a relationship between a crystallization ratio of semiconductor film 2 shown in Fig. 1 and a position of the surface of substrate 1, and Fig. 3 (b) shows a relationship between ease of peeling of semiconductor film 2 shown in Fig. 1 and a position of the surface of substrate 1.

As shown in Fig. 3(b), in semiconductor film 2 shown in Fig. 1, the crystallization ratio of semiconductor film 2 in the peripheral region (the region between solid line 21 and solid line 23 in Fig. 2) is higher than the crystallization ratio of semiconductor film 2 in the central region (the region surrounded by solid line 22 in Fig. 3).

Therefore, in semiconductor film 2 shown in Fig. 1, a frequency of occurrence of peeling of semiconductor film 2 from substrate 1 in the peripheral region can be suppressed to the same level as a frequency of occurrence of peeling of semiconductor film 2 from substrate 1 in the central region as shown in Fig. 3(b). Therefore, peeling of semiconductor film 2 from substrate 1 can be effectively suppressed. The reason for this is considered as follows: by making the crystallization ratio of semiconductor film 2 in the peripheral region where peeling of semiconductor film 2 easily occurs higher than the crystallization ratio of semiconductor film 2 in the central region, a stress generated at semiconductor film 2 in the peripheral region can be reduced. When semiconductor film 2 is made of microcrystalline silicon, for example, the density in a crystal grain boundary is lost as the crystallization ratio of semiconductor film 2 becomes higher (as the ratio of presence of an amorphous phase becomes lower) because the microcrystalline silicon has such a structure that the crystal grain boundary is filled with the amorphous phase. Therefore, by making the crystallization ratio of semiconductor film 2 in the peripheral region high, the stress generated in the peripheral region of semiconductor film 2 where peeling from substrate 1 easily occurs can be reduced, and thus, peeling of semiconductor film 2 can be effectively suppressed.

The crystallization ratio is obtained by measuring, in accordance with a Raman spectroscopy, a Raman spectrum indicated by a graph in which the vertical axis indicates a Raman scattering intensity and the horizontal axis indicates a wave number, and is defined by a peak intensity ratio Ic/Ia of magnitude Ic of peak intensity of Raman scattering intensity due to crystalline silicon having a wave number of about 520 cm$^{-1}$ to magnitude Ia of peak intensity of Raman scattering intensity due to amorphous silicon having a wave number of about 480 cm$^{-1}$.

The crystallization ratio of semiconductor film 2 in the peripheral region is preferably 4 or more. If the crystallization ratio of semiconductor film 2 in the peripheral region is set to 4 or more, the stress generated in the peripheral region of semiconductor film 2 can be reduced more greatly. Therefore, there is a tendency that peeling of semiconductor film 2 from substrate 1 can be suppressed more effectively.

The crystallization ratio of semiconductor film 2 in the central region is preferably 2 or more. By setting the crystallization ratio of semiconductor film 2 in the central region to 2 or more and reducing the stress generated in the central region of semiconductor film 2, the stress generated at the entire semiconductor film 2 can also be reduced. Therefore, there is a tendency that peeling of semiconductor film 2 from substrate 1 can be suppressed more effectively.

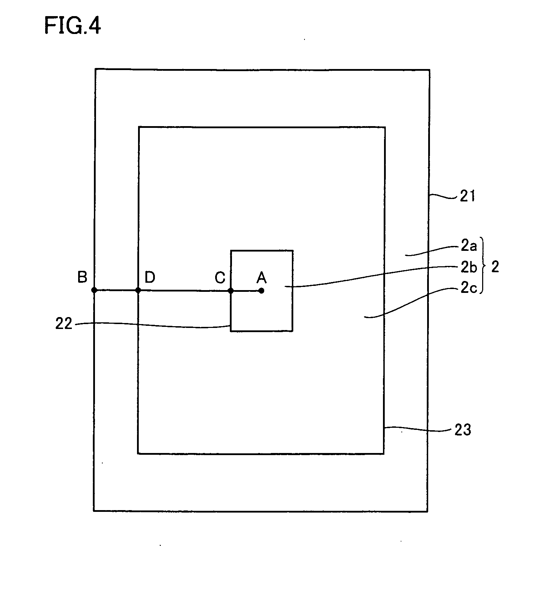

Fig. 4 shows a schematic plan view of another example of semiconductor film 2 shown in Fig. 1 as viewed two-dimensionally. Assume that a point A represents a center point of the surface of semiconductor film 2, a point B represents one arbitrary point on an outer perimeter of the surface of semiconductor film 2, a line segment AB represents a line segment connecting point A and point B, and a point C and a point D represent two different points on line segment AB. Also assume that, when point A of line segment AB is fixed and point B goes around on the outer perimeter of the surface of semiconductor film 2 while keeping a relationship that a ratio of a length of a line segment AC connecting point A and point C, a length of a line segment CD connecting point C and point D, and a length of a line segment DB connecting point D and point B (AC:CD:DB) is 17:27:6, peripheral region 2a is a portion of semiconductor film 2 in a region between a trajectory of point B (solid line 21 in Fig. 4) and a trajectory of point D (solid line 23 in Fig. 4), and central region 2b is a portion of semiconductor film 2 in a region surrounded by a trajectory of point C (solid line 22 in Fig. 4). Also assume that Xa represents the crystallization ratio of semiconductor film 2 in central region 2b, and Xb represents the crystallization ratio of semiconductor film 2 in peripheral region 2a. Then, crystallization ratio Xa and crystallization ratio Xb preferably satisfy a relationship of the following equation (i') and a relationship of the following equation (i). More preferably, crystallization ratio Xa and crystallization ratio Xb also satisfy a relationship of the following equation (ii). Particularly preferably, crystallization ratio Xa and crystallization ratio Xb also satisfy a relationship of the following equation (ii').

$$Xb \geq Xa \quad \cdots (i')$$

$$Xb \geq Xa+1 \cdots (i)$$

$$Xb \geq Xa+2 \cdots (ii)$$

$$Xb \geq Xa+3 \cdots (ii')$$

When crystallization ratio Xa of semiconductor film 2 in central region 2b and crystallization ratio Xb of semiconductor film 2 in peripheral region 2a satisfy the relationship of the above equation (i') and the relationship of the above equation (i), particularly when crystallization ratio Xa and crystallization ratio Xb satisfy the relationship of the above equation (ii), and further, when crystallization ratio Xa and crystallization ratio Xb satisfy the relationship of the above equation (ii'), there is a tendency that peeling of semiconductor film 2 from substrate 1 can be suppressed more effectively. This is derived from an experimental result described below.

The case has been described above, where the crystallization ratio of semiconductor film 2 in peripheral region 2a is higher than the crystallization ratio of semiconductor film 2 in central region 2b. However, when crystallization ratio Xa and crystallization ratio Xb satisfy a relationship of the following equation (iii) even if crystallization ratio Xa of semiconductor film 2 in central region 2b is equal to or higher than crystallization ratio Xb of semiconductor film 2 in peripheral region 2a as described in the following equation (iv), peeling of semiconductor film 2 from substrate 1 can be effectively suppressed. This is derived from the experimental result described below.

$$Xb \geq 13 - Xa \cdots (iii)$$

$$Xa \geq Xb \cdots (iv)$$

In the above equations (iii) and (iv), Xa represents the crystallization ratio of semiconductor film 2 in central region 2b shown in Fig. 4, and Xb represents the crystallization ratio of semiconductor film 2 in peripheral region 2a shown in Fig. 4.

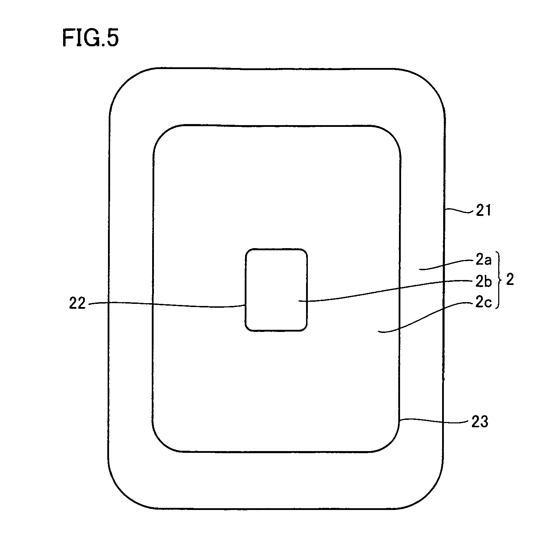

The surface shape of semiconductor film 2 is not limited to the shape shown in Figs. 2 and 4, and may be, for example, such a shape that the four corners of the surface of semiconductor film 2 are all rounded as shown in Fig. 5. In this case, the respective four corners of peripheral region 2a, central region 2b and intermediate region 2c of semiconductor film 2 are all rounded as well.

In the drawings of the present invention, solid line 21 matches a line indicating the outer perimeter of the surface of semiconductor film 2, while solid line 22 and solid line 23 are not necessarily formed on the surface of semiconductor film 2 because solid line 22 and solid line 23 are imaginary lines.

<Method for Manufacturing Semiconductor Film>

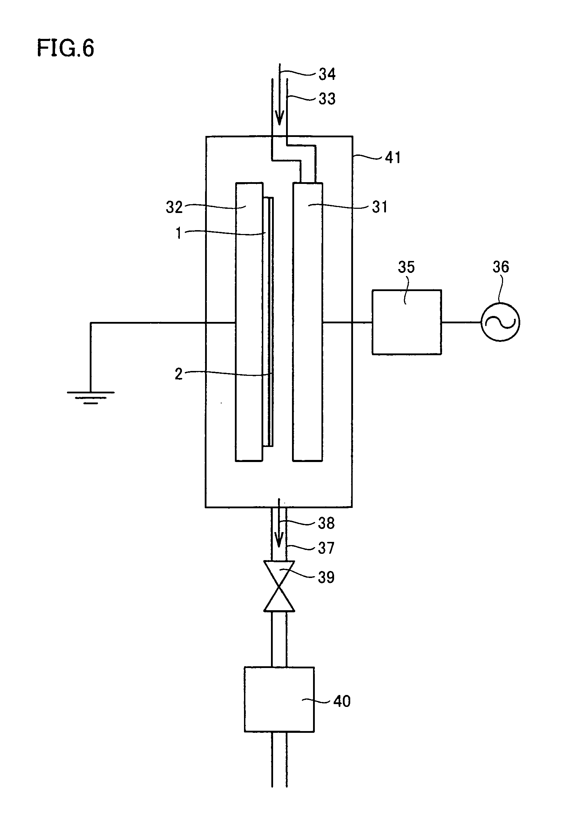

Semiconductor film 2 shown in Fig. 1 can, for example, be formed on the surface of substrate 1 as described below. Fig. 6 shows a schematic configuration of one example of a vacuum film forming device for forming semiconductor film 2 shown in Fig. 1.

The vacuum film forming device shown in Fig. 6 includes a film forming chamber 41, a cathode 31 placed within film forming chamber 41, an anode 32 placed within film forming chamber 41 to face cathode 31, a gas introduction pipe 33 for introducing a gas into cathode 31, a gas discharge pipe 37 for discharging the gas outside film forming chamber 41, a gate valve 39 for adjusting an amount of the gas discharged from gas discharge pipe 37, and a pump 40 for drawing in the gas discharged outside film forming chamber 41. Cathode 31 is connected to a high-frequency power supply 36 with an impedance matching circuit 35 interposed therebetween, and anode 32 is connected to the earth.

When semiconductor film 2 is formed, substrate 1 is first placed on a surface of anode 32 of the vacuum film forming device shown in Fig. 6. At this time, substrate 1 is placed on the surface of anode 32 such that the surface of substrate 1 faces a surface of cathode 31.

Next, gate valve 39 is opened and the gas in film forming chamber 41 is drawn in by pump 40. As a result, the gas in film forming chamber 41 is discharged outside film forming chamber 41 through gas discharge pipe 37 in a direction indicated by an arrow 38, and the pressure in film forming chamber 41 is set to the pressure ranging from $10^{-4}$ to 1 Pa, for example.

Next, a raw material gas serving as a raw material of semiconductor film 2 is introduced from gas introduction pipe 33 into cathode 31 in a direction indicated by an arrow 34, and the raw material gas is introduced between cathode 31 and anode 32 from shower plate holes (not shown) provided in cathode 31 on the anode 32 side. At least one type of gas selected from the group consisting of, for example, $SiH_4$, $H_2$, $B_2H_6$, $PH_3$, and $CH_4$ can be used as the raw material gas serving as the raw material of semiconductor film 2-.

Next, an AC voltage is applied between cathode 31 and anode 32 by high-frequency power supply 36 to generate a plasma of the raw material gas introduced as described above. Semiconductor film 2 is thus formed on the surface of substrate 1.

When semiconductor film 2 formed of a microcrystalline silicon film is formed using, for example, $SiH_4$ and $H_2$ as the raw material gas, semiconductor film 2 can be formed as follows: a system of the shower plate hole near the center of cathode 31 facing the center of the surface of substrate 1 is made independent of a system of the shower plate hole near the periphery of cathode 31 facing the periphery of the surface of substrate 1, mass flow controllers are independently attached to the respective systems, and a gas flow ratio ($H_2$ flow rate/$SiH_4$ flow rate) of the raw material gas introduced into a portion where the crystallization ratio is set to be high (e.g., the raw material gas introduced from the shower plate hole near the periphery of cathode 31) is set to be higher than a gas flow ratio ($H_2$ flow rate/$SiH_4$ flow rate) of the raw material gas introduced into the other portion (e.g., the raw material gas introduced from the shower plate hole near the center of cathode 31). The gas flow ratio ($H_2$ flow rate/$SiH_4$ flow rate) of the raw material gas is preferably 5 to 300.

The aforementioned pressure in film forming chamber 41 when semiconductor film 2 is formed can be set to the pressure ranging from $5 \times 10^2$ to $1.7 \times 10^3$ Pa, for example.

By adjusting the pressure in film forming chamber 41 and/or a distance between cathode 31 and anode 32, for example, the thickness of the surface of semiconductor film 2 in the in-plane direction can be adjusted.

By adjusting the diameter of the shower plate holes in the surface of cathode 31 and/or the number of the shower plate holes, for example, the thickness of the surface of semiconductor film 2 in the in-plane direction can also be adjusted.

In the vacuum film forming device shown in Fig. 6, high-frequency power supply 36 may be a power supply outputting AC output having a continuous wave (CW) or pulse-modulated (on-off controlled) AC output. Although AC electric power outputted from high-frequency power supply 36 has a frequency of 13.56 MHz generally, the frequency is not limited thereto. For example, a frequency ranging from several kilohertz to the VHF band, a frequency ranging from several kilohertz to the UHF band, and a frequency ranging from several kilohertz to the microwave band may be used.

<Photoelectric Conversion Device>

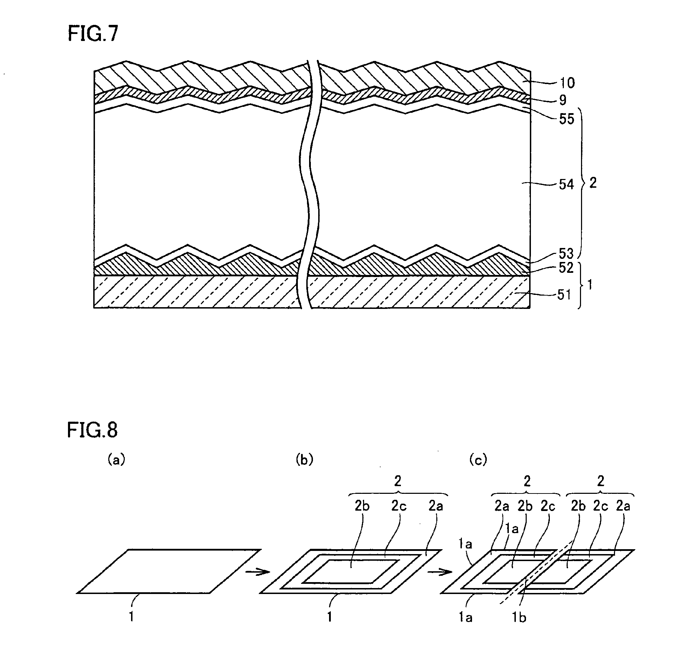

Fig. 7 shows a schematic cross-sectional view of one example of a photoelectric conversion device according to the present invention having aforementioned semiconductor film 2 on the surface of substrate 1. The photoelectric conversion device shown in Fig. 7 includes substrate 1, semiconductor film 2 provided on the surface of substrate 1, a transparent conductive film 9 provided on the surface of semiconductor film 2, and a reflection electrode 10 provided on a surface of transparent conductive film 9. A super-straight-type photoelectric conversion device in which light comes from the substrate 1 side is described here as one example of the photoelectric conversion device according to the present invention. The photoelectric conversion device according to the present invention may, however, be a sub-straight-type photoelectric conversion device in which light comes from the opposite side of substrate 1.

Substrate 1 is formed of a translucent substrate 51 and a transparent conductive film 52 provided on a surface of translucent substrate 51. Semiconductor film 2 includes a p-type microcrystalline silicon layer 53 provided on a surface of transparent conductive film 52, an i-type microcrystalline silicon layer 54 provided on a surface of p-type microcrystalline silicon layer 53, and an n-type microcrystalline silicon layer 55 provided on a surface of i-type microcrystalline silicon layer 54.

Since description of translucent substrate 51, transparent conductive film 52 and semiconductor film 2 (a stacked structure of p-type microcrystalline silicon layer 53, i-type microcrystalline silicon layer 54 and n-type microcrystalline silicon layer 55) is similar to the above, description thereof will not be repeated here.

For example, a tin oxide film, an ITO film, a zinc oxide film, or a conductive film that allows light to pass therethrough, such as a single layer of a film formed by adding a minute amount of impurity to these films or a plurality of layers formed by stacking a plurality of these layers, can be used as transparent conductive film 9. When transparent conductive film 9 is formed of the plurality of layers, all layers may be made of the same material or at least one layer may be made of a material different from that of the other layers.

Transparent conductive film 9 is not always have to be formed. It is preferable, however, to form transparent conductive film 9 because an effect of enhancing light confinement of incident light and an effect of enhancing the light reflectivity are obtained, and the presence of transparent conductive film 9 allows suppression of diffusion of atoms constituting reflection electrode 10 into semiconductor film 2.

A conductive layer such as, for example, an Ag (silver) layer, an A1 (aluminum) layer or a stacked structure of these layers can be used as reflection electrode 10. Since reflection electrode 10 can reflect light that was not absorbed in semiconductor film 2 back to semiconductor film 2, reflection electrode 10 contributes to enhancement of the photoelectric conversion efficiency. When the sub-straight-type photoelectric conversion device is used as the photoelectric conversion device, reflection electrode 10 preferably has a shape such as, for example, a comb shape that does not cover the entire surface of the photoelectric conversion device, so as to allow light to enter.

The photoelectric conversion device shown in Fig. 7 includes aforementioned semiconductor film 2, peeling of which from substrate 1 can be effectively suppressed, on the surface of substrate 1. Therefore, peeling of semiconductor film 2 from substrate 1 can be suppressed and the photoelectric conversion device can be manufactured with high yield.

In the photoelectric conversion device shown in Fig. 7, a thickness of semiconductor film 2 in central region 2b is preferably larger than a thickness of semiconductor film 2 in peripheral region 2a. In this case, there is a tendency that variations in short-circuit current density in the surface of substrate 1 of the photoelectric conversion device can be greatly reduced.

<Tandem-type Photoelectric Conversion Device>

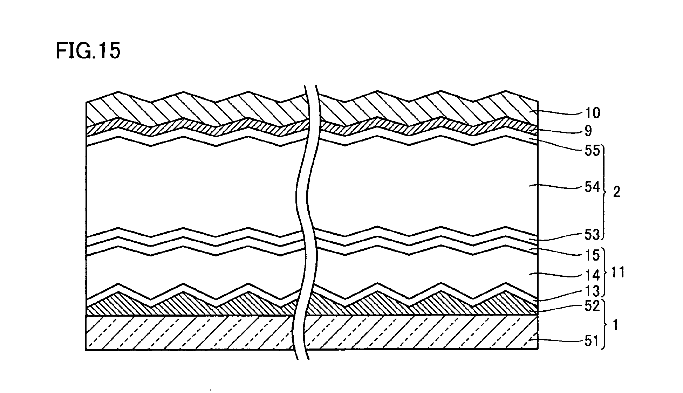

Fig. 15 shows a schematic cross-sectional view of another example of the photoelectric conversion device according to the present invention having aforementioned semiconductor film 2 on the surface of substrate 1. The photoelectric conversion device shown in Fig. 15 is a tandem-type photoelectric conversion device including, on substrate 1, a first pin-type photoelectric conversion layer 11 and semiconductor film 2 serving as a second pin-type photoelectric conversion layer.

A substrate obtained by forming transparent conductive film 52 made of $SnO_2$ on translucent substrate 51 formed of a glass substrate and having a surface of 1000 mm wide, 1400 mm long and 4 mm thick is used as substrate 1. Transparent conductive film 52 is removed and separated in the form of strips having a predetermined spacing (approximately 7 to 18 mm) by a laser scribing method.

First pin-type photoelectric conversion layer 11 is stacked on separated transparent conductive film 52.

First pin-type photoelectric conversion layer 11 is an amorphous silicon photoelectric conversion layer formed of a stacked structure of a first p-type semiconductor layer 13, a first i-type semiconductor layer 14 and a first n-type semiconductor layer 15.

A single p-type layer such as a p-type amorphous silicon layer, a p-type amorphous silicon carbide layer or a p-type amorphous silicon nitride layer, or a plurality of layers formed by stacking a plurality of these layers can, for example, be used as first p-type semiconductor layer 13. An amorphous silicon layer can, for example, be used as first i-type semiconductor layer 14. A single n-type layer such as an n-type amorphous silicon layer or an n-type microcrystalline silicon layer, or a plurality of layers formed by stacking a plurality of these layers, or the like can, for example, be used as first n-type semiconductor layer 15.

Then, semiconductor film 2 serving as the second pin-type photoelectric conversion layer formed of the stacked structure of p-type microcrystalline silicon layer 53, i-type microcrystalline silicon layer 54 and n-type microcrystalline silicon layer 55 is stacked on first pin-type photoelectric conversion layer 11.

After semiconductor film 2 is formed, a part of first pin-type photoelectric conversion layer 11 and a part of semiconductor film 2 serving as the second pin-type photoelectric conversion layer are removed at a predetermined spacing (approximately 7 to 18 nm) by the laser scribing method. As a result, first pin-type photoelectric conversion layer 11 and semiconductor film 2 serving as the second pin-type photoelectric conversion layer are separated.

Then, transparent conductive film 9 and reflection electrode 10 are stacked on separated semiconductor film 2 in this order.

After transparent conductive film 9 and reflection electrode 10 are formed, a part of first pin-type photoelectric conversion layer 11, a part of semiconductor film 2 serving as the second pin-type photoelectric conversion layer, a part of transparent conductive film 9, and a part of reflection electrode 10 are removed and separated at a predetermined spacing (approximately 7 to 18 nm) by the laser scribing method.

The tandem-type photoelectric conversion device in which a plurality of strip-shaped thin-film photoelectric conversion elements are serially connected to one another on the entire surface of substrate 1 is thus formed.

Since the remaining description of translucent substrate 51, transparent conductive film 52, semiconductor film 2 serving as the second pin-type photoelectric conversion layer, transparent conductive film 9, and reflection electrode 10 is similar to the above, description thereof will not be repeated here.

The tandem-type photoelectric conversion device fabricated as described above was irradiated with dummy sunlight of AM1.5 (100 mW/cm$^2$) at a temperature of 25°C from the side of translucent substrate 51 formed of a glass substrate, and the maximum output electric power was measured. As a result, the maximum output electric power of the tandem-type photoelectric conversion device was 150.6 W.

<Other Form of Photoelectric Conversion Device>

For example, by forming aforementioned semiconductor film 2 on the surface of substrate 1, and then, cutting substrate 1, a photoelectric conversion device (other form of photoelectric conversion device) including aforementioned semiconductor film 2 on the surface of substrate 1 can also be manufactured.

The photoelectric conversion device can also be manufactured, for example, as follows: substrate 1 is first prepared as shown in a schematic perspective view in Fig. 8(a), semiconductor film 2 is then formed on the surface of substrate 1 similarly to the above as shown in a schematic perspective view in Fig. 8(b), substrate 1 having semiconductor film 2 formed thereon is then cut along a broken line and divided into two pieces as shown in a schematic perspective view in Fig. 8(c), and transparent conductive film 9 and reflection electrode 10 are formed on each of the surfaces of semiconductor films 2 of divided substrates 1 (this method will be referred to as "first manufacturing method" hereinafter). The photoelectric conversion device can also be manufactured as follows: semiconductor film 2, transparent conductive film 9 and reflection electrode 10 are formed on the surface of substrate 1, and substrate 1 is then divided into two pieces (this method will be referred to as "second manufacturing method" hereinafter).

The other form of photoelectric conversion device manufactured as described above has a cut surface 1b exposed as a result of cutting of substrate 1, and a peripheral surface 1a of substrate 1 that has already been exposed before cutting of substrate 1.

Although the photoelectric conversion device is manufactured by dividing substrate 1 into two pieces in the above, the number of division of substrate 1 is not limited to two pieces. Substrate 1 may be divided into, for example, four pieces, six pieces or the like.

Whether the photoelectric conversion device is the other form of photoelectric conversion device or not can be determined, for example, as follows.

When the photoelectric conversion device is manufactured in accordance with the first manufacturing method, a constituent component of semiconductor film 2 may adhere to peripheral surface 1a of substrate 1, whereas the constituent component of semiconductor film 2 does not adhere to cut surface 1b of substrate 1. Therefore, it may only be determined whether or not the constituent component of semiconductor film 2 adheres to the side surface of substrate 1 of the photoelectric conversion device.

When the photoelectric conversion device is manufactured in accordance with the second manufacturing method, constituent components of transparent conductive film 9 and reflection electrode 10 may adhere to peripheral surface 1a of substrate 1, whereas the constituent components of transparent conductive film 9 and reflection electrode 10 do not adhere to cut surface 1b of substrate 1. Therefore, it may only be determined whether or not the constituent components of transparent conductive film 9 and reflection electrode 10 adhere to the side surface of substrate 1 of the photoelectric conversion device. Example

<Fabrication of Semiconductor Films in Experimental Examples 1 to 8>

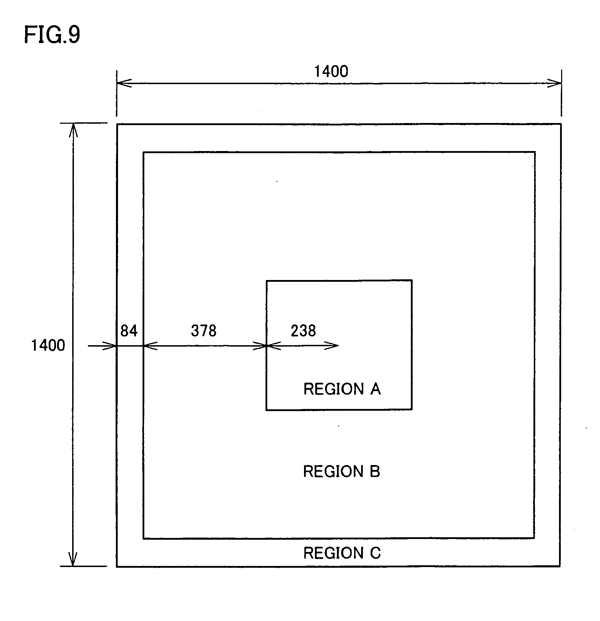

First, a glass substrate having a surface of 1400 mm wide, 1400 mm long and 4 mm thick as shown in a schematic plan view in Fig. 9 was placed in a magnetron sputtering device, and a zinc oxide layer having a thickness of 500 nm was formed on a surface of the glass substrate by a magnetron sputtering method. A composite substrate of the glass substrate and the zinc oxide layer was thus formed.

Next, the composite substrate thus fabricated was placed in the film forming chamber of the vacuum film forming device, and the gas in the film forming chamber was removed until the pressure in the film forming chamber reached 0.1 Pa. Thereafter, the raw material gas, which was a mixed gas of $H_2$ gas and $SiH_4$ gas, was introduced from the cathode placed in the film forming chamber to face a surface of the composite substrate, and by adjusting a film forming time, each of semiconductor films in Experimental Examples 1 to 8 formed of a microcrystalline silicon film was formed on a surface of the zinc oxide layer of the composite substrate by a plasma CVD method such that the semiconductor film had an in-plane average film thickness of 2500 nm.

Each of the semiconductor films in Experimental Examples 1 to 8 was formed by changing the gas flow ratio ($H_2$ flow rate/$SiH_4$ flow rate) of the $H_2$ gas and the $SiH_4$ gas introduced from the shower plate hole near the center of the cathode and the shower plate hole near the periphery of the cathode in the film forming chamber of the vacuum film forming device.

<Evaluation of Semiconductor Films in Experimental Examples 1 to 8>

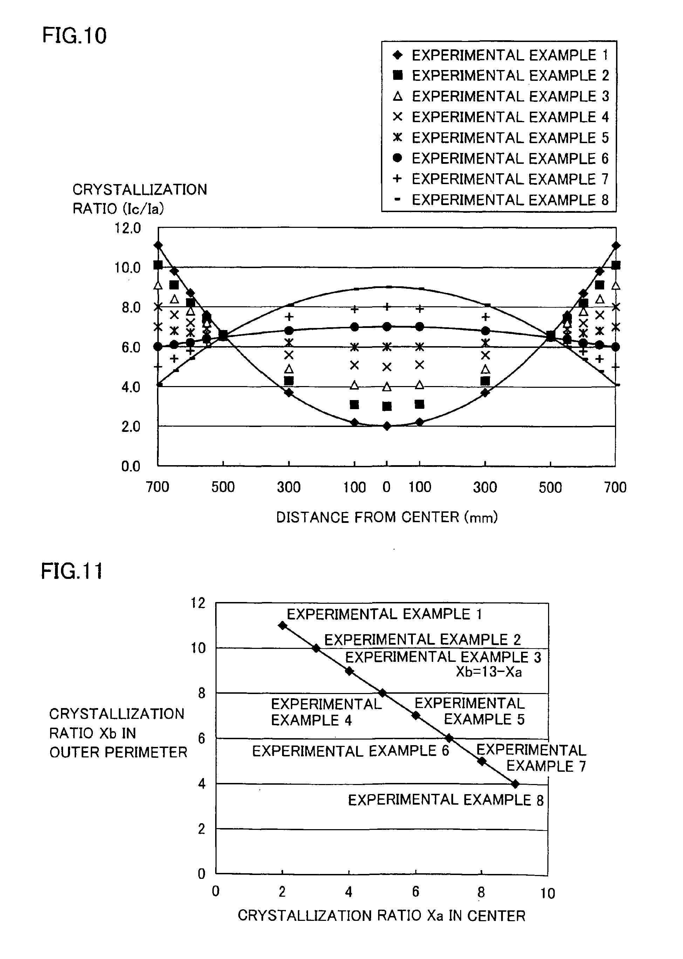

Crystallization ratio Ic/Ia of each of the semiconductor films in Experimental Examples 1 to 8 fabricated as described above was measured at the center of the semiconductor film, at a point 100 mm away from the center of the semiconductor film, at a point 300 mm away from the center of the semiconductor film, at a point 500 mm away from the center of the semiconductor film, at a point 550 mm away from the center of the semiconductor film, at a point 600 mm away from the center of the semiconductor film, at a point 650 mm away from the center of the semiconductor film, and at a point 700 mm away from the center of the semiconductor film (at the points other than the center of the semiconductor film, crystallization ratio Ic/Ia was obtained by measuring crystallization ratios at a plurality of points having the distance from the center of the semiconductor film, and calculating an average value thereof). The result is shown in Fig. 10. In Fig. 10, the horizontal axis indicates a distance (mm) from the center of a surface of the semiconductor film, and the vertical axis indicates crystallization ratio Ic/Ia. Crystallization ratio Ic/Ia was obtained by measuring, in accordance with a Raman spectroscopy, a Raman spectrum indicated by a graph in which the vertical axis indicates a Raman scattering intensity and the horizontal axis indicates a wave number, and was defined by a peak intensity ratio Ic/Ia of magnitude Ic of peak intensity of Raman scattering intensity due to crystalline silicon having a wave number of about 520 cm$^{-1}$ to magnitude Ia of peak intensity of Raman scattering intensity due to amorphous silicon having a wave number of about 480 cm$^{-1}$.

As shown in Fig. 10, in the semiconductor films in Experimental Examples 1 to 5, crystallization ratio Ic/Ia in a peripheral region C (semiconductor film on region C in Fig. 9) was higher than crystallization ratio Ic/Ia in a central region A (semiconductor film on region A in Fig.

9). On the other hand, in the semiconductor films in Experimental Examples 6 to 8, crystallization ratio Ic/Ia in central region A (semiconductor film on region A in Fig. 9) was higher than crystallization ratio Ic/Ia in peripheral region C (semiconductor film on region C in Fig. 9).

As shown in Fig. 9, a boundary between central region A and an intermediate region B (semiconductor film on region B in Fig. 9) is located at a position 238 mm away from the center of the semiconductor film in the length direction (width direction) of the semiconductor film. A boundary between intermediate region B and peripheral region C is located at a position 378 mm away from the boundary between central region A and intermediate region B in the length direction (width direction) of the semiconductor film. Furthermore, an outer perimeter of the semiconductor film is located at a position 84 mm away from the boundary between intermediate region B and peripheral region C in the length direction (width direction) of the semiconductor film. Therefore, assuming that a point A represents the center of the semiconductor film, a point B represents one arbitrary point on the outer perimeter of the surface of the semiconductor film, a line segment AB represents a line segment connecting point A and point B, a point C represents an intersection of line segment AB and an outer perimeter of central region A, and a point D represents an intersection of line segment AB and an outer perimeter of intermediate region B, a length of a line segment AC : a length of a line segment CD : a length of a line segment DB = 238:378:84 = 17:27:6.

Fig. 11 shows a relationship between crystallization ratio Xa in the center of each of the semiconductor films in Experimental Examples 1 to 8 and crystallization ratio Xb in the outer perimeter (point 700 mm away from the center of the semiconductor film) of each of the semiconductor films in Experimental Examples 1 to 8. In Fig. 11, the horizontal axis indicates crystallization ratio Xa in the center of each of the semiconductor films in Experimental Examples 1 to 8, and the vertical axis indicates crystallization ratio Xb in the outer perimeter of each of the semiconductor films in Experimental Examples 1 to 8.

As shown in Fig. 11, it was confirmed that crystallization ratio Xa in the center of each of the semiconductor films in Experimental Examples 1 to 8 and crystallization ratio Xb in the outer perimeter of each of the semiconductor films in Experimental Examples 1 to 8 have a linear relationship expressed in the equation of Xb=13—Xa.

Next, like Experimental Examples 1, 6 and 8 in Fig. 10, crystallization ratio Ic/Ia of each of the semiconductor films in Experimental Examples 1 to 8 was connected with a line, distances from the center of the semiconductor film where crystallization ratio Ic/Ia was 2, 3, 4, 5, 6, 7, 8, 9, 10, and 11 were identified for each of the semiconductor films in Experimental Examples 1 to 8, and the presence or absence of peeling of the semiconductor film was checked at each of a plurality of points having the identified distances. The result is shown in Fig. 12. The presence or absence of peeling of the semiconductor film was checked by leaving the semiconductor films in Experimental Examples 1 to 8 in the atmosphere for 24 hours after formation of the semiconductor films in Experimental Examples 1 to 8 by the plasma CVD method, taking a picture of a film surface by means of an optical microscope, enhancing the contrast of the obtained image to obtain a black and white image, and calculating a ratio of an area of the white portion in this image. Since a portion where the semiconductor film peels off has high brightness usually, the ratio of the area of the white portion obtained in accordance with the aforementioned method corresponds to a ratio of an area (peeling area) of the portion where the semiconductor film peels off. An inspection machine manufactured by Orbotech Ltd. was used as a measuring device.

2 to 9 of crystallization ratio Xa in the horizontal axis in Fig. 12 correspond to crystallization ratios Ic/Ia in the centers of the surfaces of the semiconductor films in Experimental Examples 1 to 8, respectively, and 2 to 11 of crystallization ratio Xb in the vertical axis correspond to 2 to 11 of crystallization ratio Ic/Ia at the aforementioned respective points of each of the semiconductor films in Experimental Examples 1 to 8, respectively. A to E in Fig. 12 indicate the following evaluations:

A ··· The semiconductor film does not peel off at 99% or more of all measurement points.
B ··· The semiconductor film does not peel off at 98% or more of all measurement points.
C ··· The semiconductor film does not peel off at 95% or more of all measurement points.
D ··· The semiconductor film does not peel off at 92% or more of all measurement points.
E ··· The semiconductor film does not peel off at 90% or more of all measurement points.

As shown in Fig. 12, in the semiconductor films in Experimental Examples 1 to 5 in which crystallization ratio Ic/Ia in peripheral region C was higher than crystallization ratio Ic/Ia in central region A (2 to 5 of crystallization ratio Xa in the center in Fig. 12), all evaluations were D or higher when crystallization ratio Xa and crystallization ratio Xb satisfied the relationships of the following equations (i') and (i). When crystallization ratio Xa and crystallization ratio Xb satisfied the relationship of the following equation (ii), all evaluations were B or higher. When crystallization ratio Xa and crystallization ratio Xb satisfied the relationship of the following equation (ii'), all evaluations were A or higher. Therefore, it was confirmed that peeling of the semiconductor film can be effectively suppressed in each case.

$$Xb \geq Xa \quad \cdots (i')$$

$$Xb \geq Xa+1 \cdots (i)$$

$$Xb \geq Xa+2 \cdots (ii)$$

$$Xb \geq Xa+3 \cdots (ii')$$

In addition, as shown in Fig. 12, in the semiconductor films in Experimental Examples 6 to 8 in which crystallization ratio Ic/Ia in central region A was higher than crystallization ratio Ic/Ia in peripheral region C (6 to 8 of crystallization ratio Xa in the center in Fig. 12), all evaluations were A or higher when crystallization ratio Xa and crystallization ratio Xb satisfied the relationships of the following equations (iii) and (iv). Therefore, it was confirmed that peeling of the semiconductor film can be effectively suppressed.

$$Xb \geq 13 - Xa \cdots (iii)$$

$$Xa \geq Xb \cdots (iv)$$

It should be understood that the embodiments and examples disclosed herein are illustrative and not limitative in any respect. The scope of the present invention is defined by the terms of the claims, rather than the description above, and is intended to include any modifications within the scope and meaning equivalent to the terms of the claims.

INDUSTRIAL APPLICABILITY

The present invention can be used in the semiconductor film and the photoelectric conversion device.

REFERENCE SIGNS LIST

1 substrate; 1a peripheral surface; 1b cut surface; 2 semiconductor film; 2a peripheral region; 2b central region; 2c intermediate region; 9 transparent conductive film; 10 reflection electrode; 11 first pin-type photoelectric conversion layer; 13 first p-type semiconductor layer; 14 first i-type semiconductor layer; 15 first n-type semiconductor layer; 21, 22, 23 solid line; 31 cathode; 32 anode; 33 gas introduction pipe; 34, 38 arrow; 35 impedance matching circuit; 36 high-frequency power supply; 37 gas discharge pipe; 39 gate valve; 40 pump; 41 film forming chamber; 51 translucent substrate; 52 transparent conductive film; 53 p-type microcrystalline silicon layer; 54 i-type microcrystalline silicon layer; 55 n-type microcrystalline silicon layer; 101 transparent insulating substrate; 102 first transparent electrode; 103 p-type microcrystalline Si layer (p layer); 104 i-type microcrystalline Si layer (i layer); 105 n-type microcrystalline Si layer (n layer); 106 second transparent electrode; 107 backside electrode; 108 microcrystalline Si photoelectric conversion layer

Claims

1. A semiconductor film (2) formed on a surface of a substrate (1) and containing a crystalline substance, wherein
   the semiconductor film (2) has a central region (2b) including a center of a surface of the semiconductor film (2) and a peripheral region (2a) located around said central region (2b), and
   a crystallization ratio of the semiconductor film (2) in said peripheral region (2a) is higher than a crystallization ratio in said central region (2b).

2. The semiconductor film (2) according to claim 1, wherein
   the crystallization ratio of said semiconductor film (2) in said peripheral region (2a) is 4 or more.

3. The semiconductor film (2) according to claim 1 or 2, wherein
   the crystallization ratio of said semiconductor film (2) in said central region (2b) is 2 or more.

4. The semiconductor film (2) according to any one of claims 1 to 3, wherein the surface of said semiconductor film (2) has an area of 1 m² or larger.

5. The semiconductor film (2) according to any one of claims 1 to 4, wherein assuming that:

   a point A represents a center point of the surface of said semiconductor film (2);
   a point B represents one arbitrary point on an outer perimeter of the surface of said semiconductor film (2);
   a line segment AB represents a line segment connecting said point A and said point B;
   a point C and a point D represent two different points on said line segment AB;
   when a ratio of a length of a line segment AC connecting said point A and said point C, a length of a line segment CD connecting said point C and said point D, and a length of a line segment DB connecting said point D and said point B (AC:CD:DB) is 17:27:6,
   said central region (2b) is a region surrounded by a trajectory of said point C when said point A of said line segment AB is fixed and said point B goes around on the outer perimeter of the surface of said semiconductor film (2), and
said peripheral region (2a) is a region between a trajectory of said point B and a trajectory of said point D when said point A of said line segment AB is fixed and said point B goes around on the outer perimeter of the surface of said semiconductor film (2);

Xa represents said crystallization ratio of said semiconductor film (2) in said central region (2b); and

Xb represents said crystallization ratio of said semiconductor film (2) in said peripheral region (2a),

said crystallization ratio Xa and said crystallization ratio Xb satisfy a following equation (i):

$$Xb \geq Xa+1 \cdots (i).$$

6. The semiconductor film (2) according to claim 5, wherein
said crystallization ratio Xa and said crystallization ratio Xb further satisfy a following equation (ii):

$$Xb \geq Xa+2 \cdots (ii).$$

7. A semiconductor film (2) formed on a surface of a substrate (1) and containing a crystalline substance, wherein
the semiconductor film (2) has a central region (2b) including a center of a surface of the semiconductor film (2) and a peripheral region (2a) located around said central region (2b), and
assuming that:

a point A represents a center point of the surface of said semiconductor film (2);
a point B represents one arbitrary point on an outer perimeter of the surface of said semiconductor film (2);
a line segment AB represents a line segment connecting said point A and said point B;
a point C and a point D represent two different points on said line segment AB;
when a ratio of a length of a line segment AC connecting said point A and said point C, a length of a line segment CD connecting said point C and said point D, and a length of a line segment DB connecting said point D and said point B (AC:CD:DB) is 17:27:6,
said central region (2b) is a region surrounded by a trajectory of said point C when said point A of said line segment AB is fixed and said point B goes around on the outer perimeter of the surface of said semiconductor film (2), and

said peripheral region (2a) is a region between a trajectory of said point B and a trajectory of said point D when said point A of said line segment AB is fixed and said point B goes around on the outer perimeter of the surface of said semiconductor film (2);

Xa represents said crystallization ratio of said semiconductor film (2) in said central region (2b); and

Xb represents said crystallization ratio of said semiconductor film (2) in said peripheral region (2a),

said crystallization ratio Xa and said crystallization ratio Xb satisfy following equations (iii) and (iv):

$$Xb \geq 13 - Xa \cdots (iii)$$

$$Xa \geq Xb \cdots (iv).$$

8. A photoelectric conversion device fabricated by forming the semiconductor film (2) as recited in any one of claims 1 to 7 on the substrate (1).

9. A photoelectric conversion device fabricated by cutting the substrate (1) as recited in claim 8.

FIG.1

FIG.2

FIG.3

(a)

CRYSTALLIZATION RATIO

SUBSTRATE SURFACE
POSITION

PERIPHERY          CENTER          PERIPHERY

(b)

EASE OF PEELING

SUBSTRATE SURFACE
POSITION

PERIPHERY          CENTER          PERIPHERY

FIG.4

FIG.5

FIG.6

FIG.7

FIG.8

(a)            (b)            (c)

FIG.9

FIG.10

FIG.11

## FIG.12

| Crystallization Ratio Xb | 2 | 3 | 4 | 5 | 6 | 7 | 8 | 9 |
|---|---|---|---|---|---|---|---|---|
| 11 | A | A | A | A | A | A | A | A |
| 10 | A | A | A | A | A | A | A | A |
| 9 | A | A | A | A | A | A | A | A |
| 8 | A | A | A | A | A | A | A | A |
| 7 | A | A | A | A | A | A | A | A |
| 6 | A | A | B | C | E | A | A | A |
| 5 | A | B | C | E | E | E | A | A |
| 4 | B | C | E | E | E | E | E | A |
| 3 | D | E | E | E | E | E | E | E |
| 2 | E | E | E | E | E | E | E | E |

(EXPERIMENTAL EXAMPLE 1) (EXPERIMENTAL EXAMPLE 2) (EXPERIMENTAL EXAMPLE 3) (EXPERIMENTAL EXAMPLE 4) (EXPERIMENTAL EXAMPLE 5) (EXPERIMENTAL EXAMPLE 6) (EXPERIMENTAL EXAMPLE 7) (EXPERIMENTAL EXAMPLE 8)

CRYSTALLIZATION RATIO Xa

## FIG.13

101
102
103
104 } 108
105
106
107

# FIG.14

(a)

~108

~101

(b)

CRYSTALLIZATION RATIO

SUBSTRATE SURFACE
POSITION

PERIPHERY      CENTER      PERIPHERY

(c)

EASE OF PEELING

SUBSTRATE SURFACE
POSITION

PERIPHERY      CENTER      PERIPHERY

FIG.15

## INTERNATIONAL SEARCH REPORT

| | International application No. |
|---|---|
| | PCT/JP2010/073747 |

### A. CLASSIFICATION OF SUBJECT MATTER
*H01L21/205*(2006.01)i, *H01L31/075*(2006.01)i

According to International Patent Classification (IPC) or to both national classification and IPC

### B. FIELDS SEARCHED

Minimum documentation searched (classification system followed by classification symbols)
H01L21/205, H01L31/00-31/20

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 7-183535 A (Semiconductor Energy Laboratory), 21 July 1998 (21.07.1998), & US 5705829 A & KR 10-0315888 B1 & US 2002/0130323 A1 & US 2004/0232491 A1 & US 2006/0068569 A1 & US 2008/0286950 A1 | 1-9 |
| A | JP 11-251612 A (Canon Inc.), 17 September 1999 (17.09.1999), & US 2002/0037602 A1 | 1-9 |
| A | JP 2007-266094 A (Mitsubishi Heavy Industries, Ltd.), 11 October 2007 (11.10.2007), (Family: none) | 1-9 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 02 February, 2011 (02.02.11) | 15 February, 2011 (15.02.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2010/073747

C (Continuation).   DOCUMENTS CONSIDERED TO BE RELEVANT

| Category* | Citation of document, with indication, where appropriate, of the relevant passages | Relevant to claim No. |
|---|---|---|
| A | WO 2009/119124 A1  (Mitsubishi Heavy Industries, Ltd.), 01 October 2009 (01.10.2009), & JP 2009-246029 A      & KR 10-2010-0028113 A & EP 2200092 A1          & CN 101779294 A & US 2010/0206373 A | 1-9 |
| A | WO 2009/031520 A1  (Sharp Corp.), 12 March 2009 (12.03.2009), & EP 2202785 A1          & US 2010/0193915 A | 1-9 |
| A | WO 2009/145068 A1  (Mitsubishi Electric Corp.), 03 December 2009 (03.12.2009), (Family: none) | 1-9 |
| A | JP 2006-120712 A  (Kaneka Corp.), 11 May 2006 (11.05.2006), (Family: none) | 1-9 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2009038317 A